(19) Europäisches Patentamt
European Patent Office
Office européen des brevets

(11) Veröffentlichungsnummer: **0 064 703 A1**

# (12) EUROPÄISCHE PATENTANMELDUNG

(21) Anmeldenummer: 82103738.9

(22) Anmeldetag: 03.05.82

(51) Int. Cl.³: H 01 B 1/12
H 01 L 31/02, H 01 L 29/28
C 08 G 73/00

(30) Priorität: 11.05.81 DE 3118630

(43) Veröffentlichungstag der Anmeldung: 17.11.82 Patentblatt 82/46

(84) Benannte Vertragsstaaten: BE DE FR GB NL

(71) Anmelder: **BASF Aktiengesellschaft**
**Carl-Bosch-Strasse 38**
**D-6700 Ludwigshafen(DE)**

(72) Erfinder: **Naarmann, Herbert, Dr.**
**Haardtblick 15**
**D-6719 Wattenheim(DE)**

(72) Erfinder: **Penzien, Dr.**
**Bensheimer Ring 18**
**D-6710 Frankenthal(DE)**

(72) Erfinder: **Schlag, Johannes, Dr.**
**Leuschnerstrasse 36**
**D-6700 Ludwigshafen(DE)**

(72) Erfinder: **Simak, Petr, Dr.**
**Philipp-Scheidemann-Strasse 17**
**D-6700 Ludwigshafen(DE)**

(54) **Verfahren zur Herstellung von elektrisch leitfähigen Polymeren und deren Verwendung in der Elektrotechnik und zur antistatischen Ausrüstung von Kunststoffen.**

(57) Die Erfindung betrifft ein Verfahren zur Herstellung von stabilen elektrisch leitfähigen Polymeren mit elektrischen Leitfähigkeiten größer als $10^{-2}$ S/cm, wobei Polyacetylene mit 1 bis 100, bevorzugt 10 bis 33 Gew.-% Tosylmethylisocyanid und 0,1 bis 70, bevorzugt 5 bis 35 Gew.-% eines Alkalimetalls, dessen Amids oder einer Lewis-Säure umgesetzt wird. Die erhaltenen Polymeren können in der Elektrotechnik zur Herstellung von Sonnenzellen, zur Umwandlung und Fixierung von Strahlung, zur Herstellung elektrischer und magnetischer Schalter und elektrischer Speicher und zur antistatischen Ausrüstung von Kunststoffen verwendet werden.

EP 0 064 703 A1

# Verfahren zur Herstellung von elektrisch leitfähigen Polymeren und deren Verwendung in der Elektrotechnik und zur antistatischen Ausrüstung von Kunststoffen

Die Erfindung betrifft ein Verfahren zur Herstellung von stabilen elektrisch leitfähigen Polymeren mit elektrischen Leitfähigkeiten größer als $10^{-2}$ S/cm aus Polyacetylenen.

Es ist bereits in der DE-OS 30 29 206, der DE-OS 30 27 529 und der DE-OS 30 26 328 vorgeschlagen worden, Polyacetylene durch Zugabe eines Komplexierungsmittels wie Schwermetallphosphorkomplexe, oder durch Zugabe von schwarzem Phosphor und Alkalimetall bzw. deren Amiden oder durch Zugabe von schwarzem Phosphor und einer starken Lewis-Säure in elektrisch leitfähige Polymere umzuwandeln. In der Literaturstelle DE-OS 31 04 408 ist auch bereits beschrieben, organische Polymere aus der Reihe der Polyacetylene unter Ausschluß von Wasserfeuchtigkeit und von Sauerstoff mit Nitrosoderivaten und anschließend mit einer starken Lewis-Säure mit $pk_s$-Werten von -10 bis +4 oder mit einer starken Base zu versetzen, um elektrisch leitfähige Polymere zu erhalten. Zur Herstellung von stabilen elektrisch leitfähigen Polymeren ist auch schon vorgeschlagen worden, mit Lewis-Säuren p-gedopte elektrisch leitfähige Polyacetylene unter Auschluß von Sauerstoff und Feuchtigkeit auf Temperaturen zwischen 500 und 1100°C zu erhitzen (vgl. DE-OS 31 05 948).

Der Erfindung lag die Aufgabe zugrunde, nach einfacher chemischer Verfahrensweise stabile elektrisch leitfähige Polymere auf Basis von Polyacetylen zu schaffen, ohne daß eine nachträgliche Erhitzung auf hohe Temperaturen erforderlich ist.

Rss/P

BAD ORIGINAL

Diese Aufgabe wurde dadurch gelöst, daß man Polyacetylen, jeweils bezogen auf das Polyacetylen, mit 1 bis 100 Gew.-% Tosylmethylisocyanid und 0,1 bis 70 Gew.-% eines Komplexierungsmittels umsetzt. Als Komplexierungsmittel - häufig auch Dotierungsmittel genannt - kommen in an sich bekannter Weise die Alkalimetalle, deren Amide oder eine Lewis-Säure in Betracht. Nach bevorzugter Verfahrensweise wird das Polyacetylen mit 10 bis 30 Gew.-% Tosylmethylisocyanid und 5 bis 35 Gewichtsprozent eines Alkalimetalls, dessen Amids oder einer Lewis-Säure umgesetzt. Nach besonders geeignetem Verfahren wird das Polyacetylen zuerst mit Tosylmethylisocyanid zu einem Polymeren mit Struktureinheiten der Formel:

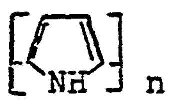 I,

wobei n = 5 bis 200 ist, und anschließend mit einem Alkalimetall, dessen Amid oder mit einer Lewis-Säure umgesetzt. Die Lewis-Säure ist bevorzugt ein Halogenderivat von Elementen der III., IV., V., VI., VII. oder VIII. Gruppe des Periodensystems der Elemente.

Unter elektrisch leitfähigen Polymeren mit elektrischen Leitfähigkeiten größer als $10^{-2}$ S/cm werden Substanzen verstanden, die nach der Meßmethode von F. Beck, "Berichte der Bunsengesellschaft, Physikalische Chemie" <u>68</u>, (1964), Seiten 558 bis 567 eine elektrische Leitfähigkeit von mehr als $10^{-2}$ S/cm aufweisen.

Die Polyacetylene d.h. die Polymerisate des Acetylens, welche erfindungsgemäß zur Anwendung kommen, werden z.B. nach den Angaben der Literaturstellen US-PS 3 092 613 hergestellt. Die Herstellung der Ausgangspolymerisate ist nicht Gegenstand der Erfindung, es wird jedoch zweckmäßig anstelle von Nickelbromid-Trihydrat mit Nitraten,

Chloriden, Acetylacetonaten und mit Kobalt als Metallion gearbeitet. Als Reduktionsmittel wird vorzugsweise statt des Natriumborhydrids Lithiumborhydrid oder Lithiumalanat verwendet, auch Phosphite, Phosphine sowie Hypophosphite sind anstelle der im US-Patent angegebenen Natriumborhydride einsetzbar. Die zur Anwendung kommenden Polyacetylene können auch nach den Literaturstellen: "Transaction of Faraday Society" 64, (1968), Seiten 823 ff., "Journal of Chemical Society, Chemical Communications" 1977, Seiten 578 bis 580 oder "Berichte der Bunsengesellschaft, Physikalische Chemie" 68, (1964), Seiten 558 bis 567 erhalten worden sein. Die Polyacetylene sind in üblichen Lösungsmitteln unlöslich und fallen als schwarze, teilkristalline Materialien an. Sie weisen Molekulargewichte von 200 bis 100 000, bestimmt nach der Literaturstelle "Makromolekulare Chemie, Rapid Communications" 1, (1980) Seite 523, auf.

Nach dem erfindungsgemäßen Verfahren werden die Polyacetylene mit 1 bis 100, bevorzugt 10 bis 30 Gew.-%, bezogen auf das Gewicht des Polyacetylens, Tosylmethylisocyanid und 0,1 bis 70, bevorzugt 5 bis 35 Gew.-%, bezogen auf das Gewicht des Polyacetylens, eines Komplexierungsmittels umgesetzt. Die Umsetzung mit Tosylmethylisocyanid erfolgt analog der Literaturstelle "Tetrahedron Letters" 1972, (52), Seiten 5337 bis 5340, wobei unter Tosylmethylisocyanid die Verbindung:

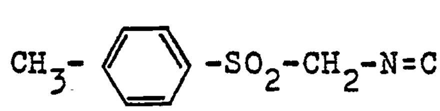

zu verstehen ist.

Hierzu kann man die Polymerisate des Acetylens, die gemäß US-PS 3 092 613 hergestellt wurden, in Gegenwart des Tosylmethylisocyanids und eines Komplexierungsmittels aus der Gruppe der Alkalimetalle, deren Amide oder der Lewis-Säuren 0,1 bis 5 Stunden auf 50 bis 250°C erhitzen und das erhaltene elektrisch leitfähige Polymere nach Entfernen der überschüssigen Zusatzstoffe in Vakuum mit Wasser waschen. Gegebenenfalls wird in Gegenwart eines Kondensationsmittels, z.B. von Kalium-tert.-butylat, gearbeitet. Nach bevorzugter Verfahrensweise wird das Polyacetylen unter obigen Verfahrensbedingungen zuerst mit Tosylmethylisocyanid zu Polymeren mit Struktureinheiten der Formel (I):

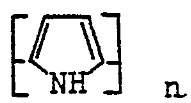 I,

wobei n = 5 bis 200 ist, und anschließend mit Alkalimetall, dessen Amid oder mit Lewis-Säure umgesetzt.

Bevorzugte Komplexierungsmittel sind unter den Alkalimetallen das Natrium oder Kalium. Unter den Alkaliamiden sind die Verbindungen des Typs $MeNH_2$ (Me = Alkalimetall) zu verstehen, bevorzugt das Natriumamid. Als Lewis-Säure wird bevorzugt ein Halogenderivat von Elementen der III., IV., V., VI., VII. oder VIII. Gruppe des Periodensystems der Elemente verwendet.

Nach besonders bevorzugter Verfahrensweise wird als Lewis-Säure $AsF_5$, $SbF_5$, $UF_6$, $SbCl_5$, $AlCl_3$, $BF_3$, $FeCl_3$, $CF_3SO_3H$, $VOCl_3$, $HClO_4$, $NO^+SbF_6^-$, $NO_2^+SbF_6^-$, $NO^+AsF_6^-$, $XeF_4$, $NO^+PF_6^-$, $I_2$, $Br_2$, $ICl$, $PF_5$, $CrO_2Cl_2$, $NO_2^+PF_6^-$, $NO^+BF_4^-$, $NO^+ClO_4^-$, $(CF_3)_2SO_4$, $NbF_5$, $WF_6$, $FeCl_3$, $CdCl_2$ oder $BF_3/CrOCl_2$ eingesetzt.

Als Lewis-Säure nach den erfindungsgemäßen Verfahren kommen ferner in Frage:

Aus der

<u>Gruppe VIII</u>

$KrF_2$, $XeOF_4$, $XeF_6$, $XeO_2F_2$, $HXeO_4$ sowie der

<u>Gruppe VII</u>

$ClF_3$, $ClF_5$, $BrF_3$, $IF_5$, $IF_7$, BrCl, BrI, $Cl_2O$, $Cl_2O_3$, $ClO_2$, $ClOClO_3$, $Cl_2O_6$, $Cl_2O_6$, $Cl_2O_7$, $Br_2O$, $BrO_2$, $Br_2O_5$, $Br_3O_2$, $BrO_3$, $I_4O_5$, $I_2O_5$, HClO, $HClO_2$, $HClO_3$, $HClO_4$, HOBr, $HBrO_2$, $HBrO_3$, $HBrO_4$, $HIO_3$, $HIO_4$, $FClO_3$, $ClF_3O$, $ClF_3O_2$, $FClO_2$, FClO, $BrO_2F$, $BrO_3F$, $IO_2F$, $IOF_3$, $IO_2F_3$, $IOF_5$ wie aus der

<u>Gruppe VI</u>

$FSO_3H$, $(FSO_3F)$, $R(SO_2F)_2$ mit R = NH, CH, FXe $(SO_3F)$, $FXe(OSeF_5)$, $FXe(OTeF_5)$, $Xe(OSeF_5)_4$, $Xe(OTeF_4)$, $FXe(OSeF_5)$, $F_{6-x}Cl(OSeF_5)_x$ mit x = 1 bis 5 FW $(OSeF_5)_x$ mit x = 1 bis 6,

sowie den

<u>Nebengruppen</u>

$AuF_5$, $PtF_6$, $IrF_6OsF_6$, $PtF_5$, $IrF_5$, $OsF_5$, $CrF_5$, $MoF_6$, $WF_5$, $MoF_5$, $VF_5$, $RuF_6$, $ReF_5$, $ReOF_5$, $CrO_2F_2$, $CrO_3$, $AuCl_3$, $PtCl_4$, $AuCl_3$

Es kommen ferner in Frage:

Aus der

<u>VI. Gruppe</u>

$CF_3(CF_2)_nSO_3H$, $ClSO_3H$, $Cl_2CHSO_3H$, sowie der

<u>V. Gruppe</u>

$HPO_2F_2$, $P_2O_3F_4$, $PF_5$, $BiX_3$ mit X = F, Cl, Br oder I, und der

IV. Gruppe

$SiF_4$, $H_2SiF_6$, $GeX_4$, $SnX_4$, $PbX_4$ mit X = F, Cl, Br, der

III. Gruppe

$BX_3$, $AlX_3$, $GaX_3$, $TlX_3$ mit X = F, Cl, Br, I sowie der

Nebengruppen

$ReF_6$, $ReCl_5$, $ReCl_4$, $ReOF_4$, $VOF_3$, $NbOF_3$, $TaOF_3$, $VCl_3$,
$VF_3$, $NbCl_5$, $TaCl_5$, $NbOCl_3$, $TnOCl_3$, $UCl_5$,
$CuX_2$, AgX, AuX (X = Cl, Br)
$ZnX_2$, $CdX_2$, $HgX_2$ (X =Cl, Br, I)
NiX, $PdX_2$, $PtX_2$, (X = Cl, Br, I)
$CoX_2$, $RhX_2$, $IrX_2$(X = Cl, Br, I)
$FeX_2$, $FeX_3$, $RuX_2$, $OsX_2$ (X = Cl, Br, I)
$MnX_2$, (X = Cl, Br, I)
$TiX_4$, $ZrX_4$ (X = F, Cl, Br, I)
$SeX_3$, $Y_3X$, $LaX_3$ Lanthanide $X_3$ (X = F, Cl, Br, I)
Actinide $X_3$, $X_5$ (X = F, Cl, Br)

Die Reaktion kann mit den gasförmigen Reaktanten oder mit Hilfssäuren wie: HF, $HOSeF_5$, $HOTeF_5$ $CF_3SO_3H$, $CF_3COOH$, $HClO_4$ oder Sulfosäuren, $CF_3PO_3H$, $(CF_3)_2$ POOH, $HPF_6$, $H_2SiF_6$, $H_2PO_2F_2$, oder in inerten Lösungsmitteln wie: $SO_2$, $SO_2Cl_2$, $SO_2F_2$, $SO_2ClF$, $CFCl_3HF$, $CH_3CN$, $CH_3NO_2$ oder $C_2H_5NO_2$ durchgeführt werden.

Die erfindungsgemäß hergestellten elektrisch leitfähigen polymeren Systeme mit elektrischen Leitfähigkeiten größer als $10^{-2}$ S/cm sind zur antistatischen Ausrüstung von Kunststoffen, zur Herstellung von Sonnenzellen, zur Umwandlung und Fixierung von Strahlung sowie zur Herstellung elektrischer und magnetischer Schalter und elektrische Speicher

geeignet. Durch die Zusätze der starken Lewis-Säure entstehen sogenannten p-Leiter und durch die Alkalizusätze entstehen n-Leiter (vgl. "Journal of Chemical Education" 46, (1969), Nr. 2, Seite 82).

Die in den folgenden Beispielen genannten Teile sind Gewichtsteile.

Beispiele 1 bis 9

100 Teile Polyacetylen, hergestellt nach der Literaturstelle US-PS 3 092 613, werden mit 20 Teilen Tosylmethylisocyanid und 15 Teilen Natriumamid versetzt und 3 Stunden bei einer Temperatur von 85°C zur Reaktion gebracht. Anschließend wird im Vakuum das nicht umgesetzte Isocyanid bei 80°C und 0,1 Torr abgezogen. Das so gewonnene und getrocknete Polymere ist elektrisch leitfähig. Bei dieser Reaktion ist Natriumamid gleichzeitig Kondensationsmittel und Komplexierungsmittel, das Leitfähigkeit vom n-Typ ergibt.

In den folgenden Beispielen sind einige Varianten der Kondensationsmittel und Komplexierungsmittel wiedergegeben und in der Tabelle werden die Eigenschaften der erfindungsgemäß hergestellten Polymeren aufgeführt. Die in den Beispielen genannten Zahlen sind Gewichtsteile.

Tabelle

| Beispiel Nr. | Kondensationsmittel (Gew.-Teile) | Komplexierungsmittel (Gew.-Teile) | elektrische Leitfähigkeit [S/cm] |
|---|---|---|---|
| 1 | 15 $NaNH_2$ | - | $3,6 \cdot 10^{-2}$ |
| 2 | 15 Na | - | $3,6 \cdot 10^{-2}$ |
| 3 | 15 $KNH_2$ | - | $4,1 \cdot 10^{-2}$ |
| 4 | 15 K | - | $2,9 \cdot 10^{-2}$ |
| 5 | 15 $NaNH_2$ | 10 Na | $5,3 \cdot 10^{-1}$ |
| 6 | 20 $NaNH_2$ | 20 Na | $6,8 \cdot 10^{-1}$ |
| 7 | 10 Na | 25 Na | $5,0 \cdot 10^{-1}$ |
| 8 | 10 Na | 25 K | $4,5 \cdot 10^{+1}$ |
| 9 | 10 Na | 25 Na | $1,9 \cdot 10^{-1}$ |

Beispiele 10 bis 13

Wird wie in den Beispielen 1 bis 9 beschrieben gearbeitet und nach der Kondensation das Natriumamid z.B. mit Dimethylformamid ausgewaschen und anschließend getrocknet, so kann zur Herstellung von p-Leitern mit Lewis-Säuren gedopt werden. In den nachfolgenden Beispielen ist die verwendete Lewis-Säure (entspricht dem p-Komplexierungsmittel) variiert.

| Beispiel Nr. | Komplexierungsmittel (Gew.-Teile) | elektrische Leitfähigkeit [S/cm] |
|---|---|---|
| 10 | 15 $H_2SO_4$ | $4,2 \cdot 10^{-2}$ |
| 11 | 15 $HClO_4$ | $5,6 \cdot 10^{-2}$ |
| 12 | 15 $BF_3$ | $1,0 \cdot 10^{-2}$ |
| 13 | 25 $VOCl_3$ | $4,8 \cdot 10^{-1}$ |

## Patentansprüche

1. Verfahren zur Herstellung von stabilen elektrisch leitfähigen Polymeren mit elektrischen Leitfähigkeiten größer als $10^{-2}$ S/cm aus Polyacetylenen, dadurch gekennzeichnet, daß das Polyacetylen mit 1 bis 100 Gew.-%, bezogen auf das Polyacetylen, Tosylmethylisocyanid und 0,1 bis 70 Gew.-%, bezogen auf das Polyacetylen, eines Komplexierungsmittels umgesetzt wird.

2. Verfahren nach Anspruch 1, dadurch gekennzeichnet, daß das Komplexierungsmittel ein Alkalimetall, ein Alkalimetallamid oder eine Lewis-Säure ist.

3. Verfahren nach Anspruch 2, dadurch gekennzeichnet, daß mit 10 bis 30 Gew.-% Tosylmethylisocyanid und 5 bis 35 Gew.-% eines Alkalimetalls, dessen Amids oder einer Lewis-Säure umgesetzt wird.

4. Verfahren nach Anspruch 2, dadurch gekennzeichnet, daß zuerst mit Tosylmethylisocyanid zu Polymeren mit Struktureinheiten der Formel (I):

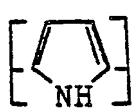 n I,

wobei n = 5 bis 200, und anschließend mit Alkalimetall, dessen Amid oder mit Lewis-Säure umgesetzt wird.

5. Verfahren nach Anspruch 2, dadurch gekennzeichnet, daß die Lewis-Säure ein Halogenderivat von Elementen der III., IV., V., VI., VII oder VIII. Gruppe des Periodensystems der Elemente ist.

6. Verwendung der nach Anspruch 1 hergestellten elektrisch leitfähigen Polymeren in der Elektrotechnik zur Herstellung von Sonnenzellen, zu Umwandlung und Fixierung von Strahlung und zur Herstellung elektrischer und magnetischer Schalter und elektrischer Speicher.

7. Verwendung der nach Anspruch 1 hergestellten elektrisch leitfähigen Polymeren zur antistatischen Ausrüstung von Kunststoffen.

0064703

Europäisches Patentamt

# EUROPÄISCHER RECHERCHENBERICHT

Nummer der Anmeldung

EP 82 10 3738

| EINSCHLÄGIGE DOKUMENTE | | | |
|---|---|---|---|
| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
| A | US-A-3 660 163 (JAMES R. MOSER) * Ansprüche; Spalte 2, Zeile 73 - Spalte 3, Zeile 14 * | 1 | H 01 B 1/12<br>H 01 L 31/02<br>H 01 L 29/28<br>C 08 G 73/00 |
| A | US-A-4 222 903 (ALAN J. HEEGER et al.) * Ansprüche * | 1 | |
| A | US-A-4 204 216 (ALAN J. HEEGER et al.) * Ansprüche * | 1 | |
| | | | RECHERCHIERTE SACHGEBIETE (Int. Cl. ³) |
| | | | H 01 B<br>H 01 L<br>C 08 L<br>C 08 G |

Der vorliegende Recherchenbericht wurde für alle Patentansprüche erstellt.

| Recherchenort | Abschlußdatum der Recherche | Prüfer |
|---|---|---|
| DEN HAAG | 22-07-1982 | MALHERBE Y.J.M. |

KATEGORIE DER GENANNTEN DOKUMENTEN

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument